Europäisches Patentamt

European Patent Office

Office européen des brevets

(11) Veröffentlichungsnummer: **0 096 266**
**B1**

(12) # EUROPÄISCHE PATENTSCHRIFT

(45) Veröffentlichungstag der Patentschrift: **28.09.88**

(51) Int. Cl.⁴: **H 01 L 23/04, H 01 L 21/60**

(21) Anmeldenummer: **83105006.7**

(22) Anmeldetag: **20.05.83**

(54) **Scheibenförmige Halbleiterzelle für druckkontaktierbare Leistungshalbleiterbauelemente.**

(30) Priorität: **09.06.82 DE 3221794**

(43) Veröffentlichungstag der Anmeldung:
**21.12.83 Patentblatt 83/51**

(45) Bekanntmachung des Hinweises auf die
Patenterteilung:
**28.09.88 Patentblatt 88/39**

(84) Benannte Vertragsstaaten:
**CH FR GB IT LI NL SE**

(56) Entgegenhaltungen:
**DE-A-1 944 181**
**FR-A-2 133 561**
**US-A-3 443 168**

(73) Patentinhaber: **BBC Brown Boveri**
**Aktiengesellschaft**
**Kallstadter Strasse 1**
**D-6800 Mannheim 31 (DE)**

(72) Erfinder: **Weimann, Klaus, Dipl.-Ing.**
**Wierdenstrasse 19**
**D-6840 Lampertheim (DE)**
Erfinder: **Eisele, Dieter, Dipl.-Phys.**
**Edisonstrasse 10**
**D-6840 Lampertheim (DE)**
Erfinder: **Hahn, Berthold**
**Schillerstrasse 28**
**D-6840 Lampertheim 5 (DE)**

(74) Vertreter: **Kempe, Wolfgang, Dr. et al**
**c/o BROWN, BOVERI & CIE AG ZPT Postfach 351**
**D-6800 Mannheim 31 (DE)**

**Beschreibung**

Die Erfindung betrifft eine scheibenförmige Halbleiterzelle für druckkontaktierbare Leistungshalbleiterbauelemente gemäß dem Oberbegriff des Patentanspruchs 1.

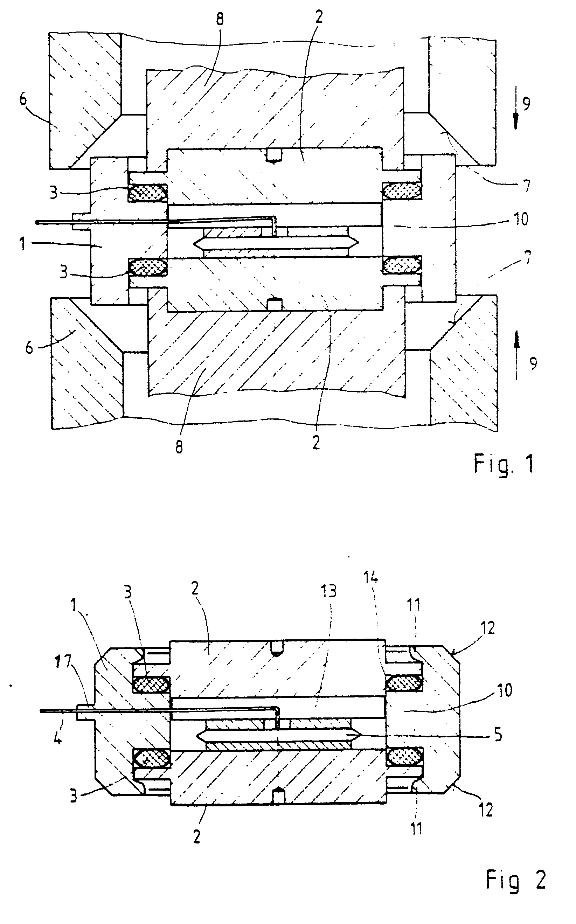

Eine derartige Scheibenzelle ist bekannt aus der DE—OS—27 19 400, Fig. 1. Bei dem bekannten Bauelement werden die Druckkontaktscheiben mit Hilfe der Dichtringe, die aus einem aushärtbaren Kleber bestehen, mit dem Gehäuse verklebt. Zur Zentrierung des Sandwiches von Halbleiterchip und Molybdän-Ronden dient gesonderter Zentrierring. Als Material für das Gehäuse wird Kunststoff oder Keramik vorgeschlagen.

Eine ähnlich aufgebaute scheibenförmige Halbleiterzelle für druckkontaktierbare Leistungshalbleiterbauelemente ist aus der DE—OS—26 54 532 bekannt. Auch hier besteht das Gehäuse aus einem Zylinderring mit einem an seiner Innenmantelfläche umlaufenden Vorsprung mit rechteckigem Querschnitt. Zur Abdichtung dienen O-Ringe, die zwischen den Vorsprung und den Druckkontaktschieben eingelegt sind. Zur Befestigung der Druckkontaktscheiben mit dem Gehäuse dienen Seegeringe, die in entsprechende, in der Nähe der Gehäusestirnfläche eingearbeitete, umlaufende Nuten in der Innenmantelfläche des Gehäuseringes eingesetzt sind. Seegeringe sind bekanntlich Sprengringe, die an ihren gegenüberstehenden Enden mit je einem Greifloch für die Montage bzw. Demontage versehen sind.

Scheibenförmige Halbleiterzellen für druckkontaktierbare Leistungshalbleiterbauelement mit einem Gehäuse aus Kunststoff sind ferner bekannt aus der US—PS—34 43 168 oder der GB—PS—11 91 232. Dabei kann das Gehäuse dadurch hergestellt werden, daß entweder der zusammengestellte Stapel von Halbleiterchip, Molybdän-Ronden und Druckkontaktscheiben mit einem thermoplastischen Kunststoff umspritzt wird, wobei durch die Anwendung von Dichtungsringen besonders sorgfältig darauf geachtet werden muß, daß das dünnflüssige Kunststoffmaterial während des Spritzvorgangs nicht in den sauber zu haltenden Innenraum gelangt, oder daß zwei vorgefertige Gehäusehälften zuammengesteckt und/oder zusammengeklebt werden, wobei in jeder Gehäusehälfte je eine Druckkontaktscheibe unter Verwendung von elastischen Blechscheiben fest eingeformt ist. Auch bei diesen bekannten Ausführungsformen sind Dichtungsringe und/oder Zentrierringe erforderlich.

Es hat sich herausgestellt, daß das Einarbeiten von Nuten in die Innenmantelfläche des Gehäuseringes wegen des zusätzlichen Arbeitsvorgangs, das Einsetzen von Seegeringen in Nuten wegen des zusätzlichen Montagevorgangs, das Kunststoffumpressen wegen der aufwendigen Dichtungen und teuren Preßwerkzeuge und -maschinen sowie das Zusammenkleben von vorgefertigten Gehäusehälften wegen des Kunststoffumpressens und des zusätzlichen Montagevorgangs die Herstellung der Bauelemente kompliziert, teilweise die zurverlässigkeit seuht und insbesondere den Preis erhöht.

Schließlich ist aus der DE—A—21 18 356 ein scheibenförmiges Halbleiterbauelement bekannt, wobei ein Stapel von Deckplatten und dazwischen angeordnetem Halbleiterchip von einem elastischen Isolierring zusammengehalten wird. Der Isolierring wird vollständig vorgefertigt und ist so elastisch, daß er aufgeschnappt werden kann. Da keine besonderen Dichtungsringe vorgesehen sind, muß der Isolierring gummiähnliche Eigenschaften haben, um dichtend zu wirken. Andererseits muß der Isolierring nach dem Aufschnappen fest genug sein, um die Teile sicher zusammenzuhalten. Es besteht daher das Problem, ein Material zur Herstellung des Isolierrings zu finden, das den sich teils widersprechenden Anforderungen gerecht wird.

Ausgehend von dem Gegenstand der DE—A—27 19 400 liegt der vorliegenden Erfindung die Aufgabe zugrunde, ein druckkontaktierbares Leistungshalbleiterbauelement anzugeben, das aus einfachen, vorgefertigten Bauteilen besteht. Außerdem soll ein einfaches Verfahren zur Herstellung angegeben werden.

Diese Aufgabe wird bei einem Leistungshalbleiterbauelement nach dem Patentanspruch 1 durch dessen kennzeichnende Merkmale gelöst. Ein Verfahren zur Herstellung des Bauelementes ist im Anspruch 5 angegeben.

Damit ergeben sich die Vorteile, daß das Gehäuse aus einem preiswerten Material besteht, welches in einer einfachen Spritzform verarbeitet werden kann, da nur glatte Fläche benötigt werden, und daß die den Rand der Druckkontaktscheiben übergreifende Schulter, die die montierte Halbleiterzelle zusammenhält, in einfachster Weise nachträglich erzeugt werden kann, indem das Kunststoffmaterial an den Stirnseiten des Zylinderrings durch die Einwirkung von Druck und/oder Wärme zum Fließen gebracht wird.

Gemäß einer vorteilhaften Weiterbildung ist ein Gate-Anschluß im Bereich des Vorsprungs in den Zylinderring eingepreßt. Dabei ist in vorteilhafter Weise im Bereich des Gate-Anschlusses am Zylinderring außen eine Nase angeformt. Diese Nase dient zusätzlich zur Erhaltung des Kriechweges zwischen den Elektroden bei vrogegebener Gehäusehöhe.

Gemäß einer vorteilhaften Weiterbildung der Erfindung ist an der Innenseite der Druckkontaktscheiben eine umlaufende Vertiefung eingeformt, in die der Dichtring einsetzbar ist. Auf diese Weise wird die Verwendung loser Dichtringe vermieden.

Zur Herstellung einer erfindungsgemäßen schiebenförmigen Halbleiterzelle werden eine als Anodenanschluß dienende Druckkontaktscheibe, ein erster Dichtring, ein Sandwich aus einem Halbleiterchip und zwei Molybdän-Ronden, ein Zylinderring mit innen umlaufendem Vorsprung, ein zweiter Dichtring und eine als Kathodenanschluß dienende Druckkontaktscheibe zentriert übereinander gestapelt; anschließend wird der Stapel in ein zweiteiliges Werkzeug eingesetzt, wo Niederhalter den Stapel und insbesondere die Dichtringe zusammenpressen und Stempel mit einer konischen Stirnseite an den Enden des Zylinderrings durch Druck- und/oder Wärmeeinwirkung die die Ränder der Druckkontaktscheiben übergreifenden Schultern formen, indem das Kunststoffmaterial zum Fließen gebracht wird.

Anhand der Zeichnung soll die Erfindung in Form eines Ausführungsbeispiels näher erläutert werden.

Es zeigen:

Fig. 1 einen Querschnitt durch eine vormontierte Halbleiterzelle, eingesetzt in ein zweiteiliges Werkzeug und

Fig. 2 einen Querschnitt durch eine fertiggestellte Scheibenzelle.

In Fig. 1 erkennt man ein Gehäuse aus einem thermoplastischen Kunststoff in Form eines Zylinderrings 1 mit einem an seiner Innenmantelfläche angeformten, umlaufenden Vorsprung 10 mit Rechteckquerschnitt. Zwischen zwei Druckkontaktscheiben 2 und dem Vorsprung 10 befinden sich Dichtringe 3, die den Innenraum der Halbleiterzelle gegen die Außenwelt abdichten.

Das vormontierte Bauelement ist in ein zweiteiliges Werkzeug eingesetzt. Niederhalter 8 pressen das vormontierte Bauelement und insbesondere die Dichtringe 3 mit einer vorgegebenen Kraft zusammen, bevor die Verformung des Kunststoffes beginnt. Zwei ringförmige, geheizte Preßstempel 6 werden anschließend in Richtung der Pfeile 9 von beiden Seiten auf die Stirnseiten des Zylinderrings 1 grepreßt. Dabei fließt das Kunststoffmaterial infolge der konischen Ausbildung der Stirnflächen 7 der Preßstempel 6 über die Ränder der Druckkontaktscheiben.

In Fig. 2 erkennt man ein fertiggestelltes Bauelement. Man erkennt den Zylinderring 1 mit Vorsprung 10 aus thermoplastischem Kunststoff, die beiden Druckkontaktscheiben 2 und die beiden Dichtringe 3 zwischen den Druckkontaktscheiben 2 und dem Vorsprung 10. Zwischen den Druckkontaktscheiben 2 ist ein Sandwich 5 aus einem Halbleiterchip und zwei Molybdän-Ronden eingespannt. Ein Gate-Anschluß 4 ist in das Gehäuse eingepreßt, wobei außen am Gehäuse eine Nase 17 angeformt ist, die hauptsächlich zur Erhöhung des Kriechweges bei vorgegebener Gehäusehöhe dient. In der oberen Druckkontaktscheibe ist eine Aussparung 13 eingearbeitet, durch die der Gate-Anschluß 4 gefürt ist.

An den Stirnseiten des Zylinderrings 1 erkennt man außen umlaufend Abschrägungen 12, welche von den konischen Stirnflächen 7 der Preßstempel 6 herrühren. Das hier weggeflossene Material bildet Schultern 11, die die Ränder der Druckkontaktscheiben 2 übergreifen und die Halbleiterzelle zusammenhalten.

Der Innenraum des Halbleiterbauelements ist vakuumdicht gegen die Außenwelt abgeschlossen. Dieser Anschluß ist insbesondere dann dauerhaft, wenn der thermische Ausdehnungskoeffizient des Kunststoffmaterials an den der Druckkörper angepaßt ist.

**Patentansprüche**

1. Scheibenförmiges, druckkontaktierbares Leistungshalbleiterbauelement, mit einem als Gehäuse dienenden Zylinderring (1), der aus Kunststoff besteht und an seiner Innenmantelfläche einen umlaufenden Vorsprung (10) mit Rechteckquerschnitt aufweist, mit zwei Druckkontaktscheiben (2), zwischen denen ein Stapel (5) aus einem Halbleiterchip und zwei Molybdän-Ronden zentriert eingespannt ist, und mit je einem Dichtring (3) zwischen den Druckkontaktscheiben (2) und dem Vorsprung (10), dadurch gekennzeichnet, daß der Zylinderring (1) aus einem thermoplastischen Kunststoff besteht, und daß der Zylinderring (1) thermoplastisch angeformte Schultern (11) aufweist, die den Rand der Druckkontaktscheibe (2) umgreifen und das Halbleiterbauelement zusammenhalten.

2. Leistungshalbleiterbauelement nach Anspruch 1, dadurch gekennzeichnet, daß ein Gate-Anschluß (4) im Bereich des Vorsprungs (10) in den Zylinderring (1) eingepreßt ist.

3. Leistungshalbleiterbauelement nach Anspruch 1 oder 2, dadurch gekennzeichnet, daß im Bereich des Gate-Anschlusses (4) am Zylinderring (1) außen eine Nase (7) angeformt ist.

4. Leistungshalbleiterbauelement nach einem der Ansprüche 1 bis 3, dadurch gekennzeichnet, daß an der Innenseite der Druckkontaktscheiben (2) eine umlaufende Vertiegung (14) eingeformt ist, in die der Dichtring (3) einsetzbar ist.

5. Verfahren zum Herstellen eines scheibenförmigen Leistungshalbleiterbauelements gemäß den Ansprüchen 1 bis 4, dadurch gekennzeichnet, daß eine als Anodenanschluß dienende Druckkontaktscheibe (2), ein erster Dichtring (3), ein Stapel (5) aus einem Halbleiterchip und zwei Molybdän-Ronden, ein Zylinderring (1) aus thermoplastischem Kunststoff mit einem innen umlaufenden Vorsprung (10), ein zweiter Dichtring (3) und eine als Kathodenanschluß dienende Druckkontaktscheibe (2) zentriert übereinander gestapelt werden, und daß diese Anordnung in ein zweiteiliges Werkzeug eingesetzt wird, wo zuerst Niederhalter (8) die Anordnung und insbesondere die Dichtringe (3) zusammenpressen und dann Stempel (6) mit einer konischen Stirnseite (7) an den Enden des Zylinderrings (1) Schultern (11) durch Druck- und/oder Wärmeeinwirkung anformen, die die Ränder der Druckkontaktscheiben (2) umgreifen.

**Revendications**

1. Composant à semiconducteur de puissance en forme de disque, à contact par pression, comportant: un anneau cylindrique (1) servant de boîtier, qui est en matière plastique et présente sur sa surface périphérique intérieure un saillant circonférentiel (10) à section droite rectangulaire, deux plaques de contact à pression (2) entre lesquelles est enserrée et centrée une pile (5) constituée par une plaquette de semiconducteur et par deux flans circulaires en molybdène, et un anneau d'étanchéité (3) entre le saillant (10) et chaque plaque de contact à pression, caractérisé par le fait que l'anneau cylindrique (1) est en une matière thermoplastique, et par le fait que l'anneau cylindrique (1) présente des épaulements (11) formés thermoplastiquement qui chevauchent le bord de la plaque de contact à pression (2) et maintiennent assemblé le composant à semiconducteur.

2. Composant à semiconducteur de puissance selon revendication 1, caractérisé par le fait qu'une borne (4) pour électrode de commande est prise dans l'anneau cylindrique (1), dans la région du saillant (10).

3. Composant à semiconducteur de puissance selon revendication 1 ou 2, caractérisé par le fait qu'un nez (7) est formé extérieurement sur l'anneau cylindrique (1), dans la région de la borne d'électrode de commande (4).

4. Composant à semiconducteur de puissance selon l'une des revendications 1 à 3, caractérisé par le fait qu'une dépression circonférentielle (14), dans laquelle l'anneau d'étanchéité (3) peut être inséré, est formée sur le côté intérieur de la plaque de contact à pression (2).

5. Procédé de fabrication d'un composant à semiconducteur de puissance en forme de disque selon les revendications 1 à 4, caractérisé par le fait que l'on empile en condition centrée une plaque de contact à pression (2) servant de borne d'anode, un premier anneau d'étanchéité (3), une pile (5) constituée par une plaquette de semiconducteur et deux flans circulaires en molybdène, un anneau cylindrique (1) en matière thermoplastique avec saillant circonférentiel intérieur (10), un deuxième anneau d'étanchéité (3) et une plaque de contact à pression servant de borne de cathode, et par le fait que l'on insère cet agencement dans un outil en deux parties où des organes de serrage (8) compriment d'abord l'agencement et notamment les anneaux d'étanchéité (3), puis, avec des poinçons (6) à face frontale conique (7) on forme aux extrémités de l'anneau cylindrique (1), par pression et/ou action de la chaleur, des épaulements (11) qui chevauchent les bords des plaques de contact à pression (2).

**Claims**

1. Disc-shaped pressure-contactable power semi-conductor component having a cylindrical ring (1) which serves as housing and which is composed of plastic and has a circumferential projection (10) with rectangular cross section on its internal surface, having two pressure-contact discs (2) between which a stack (5) composed of a semiconductor chip and two circular molybdenum blanks are clamped in a centered manner, and having in each case a sealing ring (3) between the pressure-contact discs (2) and the projection (10), characterized in that the cylindrical ring (1) is composed of a thermoplastic material and in that the cylindrical ring (1) has thermoplastically moulded-on shoulders (11) which encompass the edge of the pressure-contact disc (2) and hold the semiconductor component together.

2. Power semiconductor component according to Claim 1, characterized in that a gate contact (4) is moulded into the cylindrical ring (1) in the region of the projection (10).

3. Power semiconductor component according to Claim 1 or 2, characterized in that a boss (17) is moulded on on the outside of the cylindrical ring (1) in the region of the gate contact (4).

4. Power semiconductor component according to one of the Claims 1 to 3, characterized in that a circumferential recess (14), into which the sealing ring (3) can be inserted, is moulded in on the inside of the pressure-contact discs (2).

5. Method for producing a disc-shaped power semiconductor component according to Claims 1 to 4, characterized in that a stack is made of a pressure-contact disc (2), which serves as anode contact, a first sealing ring (3), a stack (5) composed of a semiconductor chip and two circular molybdenum blanks, a cylindrical ring (1) composed of thermoplastic material with an internally circumferential projection (10), a second sealing ring (3) and a pressure-contact disc (2), which serves as cathode contact, centered above each other, and in that this arrangement is inserted into a two-part tool in which clamping down devices (8) first press the arrangement and, in particular, the sealing rings (3) together and plungers (6) having a conical end face (7) then mould on shoulders (11) which encompass the edges of the pressure contact discs (2) at the ends of the cylindrical ring (1) as a result of exposure to pressure and/or heat.

Fig. 1

Fig 2